# EUROPEAN PATENT APPLICATION

(11) **EP 4 513 549 A1**
(43) Date of publication of application: **26.02.2025**
(21) Application number: 23811693.3
(22) Date of filing: 16.05.2023
(51) Int. Cl.: H01L 23/36, H01L 23/373, C08L 83/05, C08L 83/07, C08K 3/38

(54) **INSULATING HEAT TRANSFER SHEET**

(30) Priority: 25.05.2022 JP 2022085096
(71) Applicant: SHIN-ETSU CHEMICAL CO., LTD., Tokyo 1000005 (JP)
(72) Inventor: TSUKADA Junichi, Annaka-shi, Gunma 379-0224 (JP); IMAIZUMI Keiji, Annaka-shi, Gunma 379-0224 (JP)
(74) Representative: Angerhausen, Christoph
(86) International application number: PCT/JP2023/018274
(87) International publication number: WO 2023/228819

(57) **Abstract**

Provided is an insulating thermally conductive sheet which has excellent heat conductivity in the thickness direction, while being flexible. The insulating thermally conductive sheet according to the present invention is a cured product of a thermally conductive silicone resin composition including: (A) 100 parts by mass of a thermosetting silicone resin containing (A1) an organopolysiloxane having two or more silicon atom-bonded alkenyl groups in each molecule, (A2) an organohydrogenpolysiloxane having two or more hydrosilyl groups in each molecule, said organohydrogenpolysiloxane being composed of (A2-a) and (A2-b) and each of which has a specific structure, and (A3) a hydrosilylation catalyst; and (B) 150 to 500 parts by mass of a boron nitride that has an average particle diameter of 40 to 100 µm as determined by a laser diffraction/scattering method and an aspect ratio of 20 to 100, wherein the insulating thermally conductive sheet has an orientation degree as determined by an X-ray diffraction method in a thickness direction such that (Sum of the counts at [2Θ = 41 to 43°])/(Sum of the counts at [2Θ = 25 to 27°]) is 1 or greater.

## Description

### Technical Field

The present invention relates to a thermally conductive sheet having electrical insulating capability.

### Background Art

In recent years, further advancements in the performance of electric devices have led to the densification and high-performance packaging of semiconductor elements. This trend has also resulted in increased heat generation from the electronic components within these devices, making efficient heat dissipation essential. To deal with this, a heat-dissipating component such as a heatsink is generally used to dissipate heat generated from heating elements. It is known that placing a heat dissipation sheet between a heating element and a cooling element serves to enhance thermally conductive efficiency.

In particular, automobiles have become increasingly electronic, with an increasing number of electronic components installed, leading to an increased demand for heat dissipation materials. Heat dissipation materials are available in the form of sheets and grease. The sheet type material is often preferred due to its ease of mounting. Moreover, such dissipation materials require further enhancement in thermal conductivity to meet the demands of self-driving technology. Generally, in order to achieve high thermal conductivity, it is necessary to increase the filling rate of the filler dispersed within the polymer, which tends to result in a high specific gravity. However, this poses a problem when it comes to promoting weight reduction for improving the fuel efficiency of gasoline-powered vehicles and the electricity efficiency of electric vehicles.

For example, Patent document 1 proposes a method of producing a thermally conductive resin sheet, including essentially of a curing step of extruding a thermally conductive composition, containing a polymer, an anisotropic filler, and a filler, by means of an extruder to cure the extruded molded product to obtain a cured product, and a cutting step of cutting the cured product to a predefined thickness using an ultrasonic cutter in a direction perpendicular to the extrusion direction.

Similarly, Patent document 2 proposes a method of producing a thermally conductive sheet, including applying a magnetic field to a thermally conductive composition containing a polymer, an anisotropic thermally conductive filler, and a filler to orient the anisotropic thermally conductive filler, forming a block-like molded body, and slicing the block-like molded body to a desired thickness of the sheet.

Additionally, Patent document 3 proposes a method of producing a thermally conductive sheet, including: roll molding, press molding, extrusion molding, or coating a thermally conductive composition, containing a polymer, an anisotropic filler, and a filler, to a thickness smaller than or equal to 20 times the average value of the lengths of the major axis of the anisotropic fillers to form oriented primary sheets, and then slicing a molded product of the primary sheets being stacked and laminated with each other.

Likewise, Patent document 4 proposes a method of producing an insulating thermally conductive sheet, including: highly filling boron nitrides having plate shape into an aramid resin and orienting these to form primary sheets, and then slicing a molded product in which adhesive insulation layers are applied and laminated.

However, the thermally conductive sheets, obtained using these conventional methods, tend to have enhanced degrees of hardness in sheet because the highly charged and oriented anisotropic fillers of, for example, boron nitride tend to have increased degrees of hardness. For this reason, the thermally conductive sheets, obtained by the conventional methods, have a problem in that they have poor adhesion to heat-generating components and are unable to exhibit sufficient heat dissipation capabilities.

In addition, thermally conductive sheets generally expand and contract under the influence of the heat-generating components heating up and down. This raises serious concerns about long-term reliability when the laminated interface is made of different materials or has different hardness.

### Prior Art Documents

### Patent documents

Patent document 1: JP-A-2012-023335
Patent document 2: JP-A-2019-186555
Patent document 3: JP-A-2017-126614
Patent document 4: WO2021/090929

### Summary of Invention

### Technical Problem

Accordingly, it is an object of the present invention to provide an insulating thermally conductive sheet which has excellent heat conductivity in the thickness direction, while being flexible.

### Solution to Problem

The inventor has conducted a series of intensive studies to solve the foregoing problem and has consequently found out an idea of highly orienting boron nitrides to control the crosslinked structure of silicone resin for obtaining an insulating thermally conductive sheet which has excellent heat conductivity in the thickness direction, while being flexible, thus completing the invention

That is, the present invention provides the following insulating thermally conductive sheet.

<1> An insulating thermally conductive sheet of a cured product of a thermally conductive silicone resin composition comprising:
   (A) 100 parts by mass of a thermosetting silicone resin containing the following components (A1) to (A3) of
      (A1) an organopolysiloxane having two or more silicon atom-bonded alkenyl groups in each molecule,
      (A2) an organohydrogenpolysiloxane in an amount such that a molar ratio of the total amount of hydrosilyl groups in the component (A2) to the amount of the silicon atom-bonded alkenyl groups in the component (A1) is 0.7 to 1.0, said organohydrogenpolysiloxane being composed of the following components (A2-a) and (A2-b) of
         (A2-a) an organohydrogenpolysiloxane defined by the following formula (a): 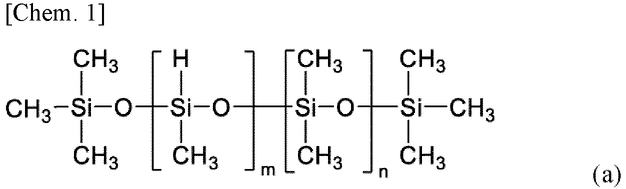 wherein m is 2 or 3, n is a number of 10 to 50, and the bonding arrangement of siloxane units each identified by m and n in brackets may be blocked or random, and
         (A2-b) an organohydrogenpolysiloxane defined by the following formula (b): 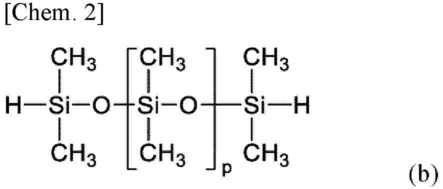 wherein p is a number of 10 to 30,
            wherein a molar ratio between the components (A2-a) and (A2-b) is determined such that the component (A2-a):the component (A2-b) = 1:0.2 to 1:2, and
      (A3) a hydrosilylation catalyst in an amount of 100 to 3,000 ppm in terms of platinum group metal atom per 100 parts by mass of the component (A1); and
   (B) 150 to 500 parts by mass of a boron nitride that has an average particle diameter of 40 to 100 µm as determined by a laser diffraction/scattering method and an aspect ratio of 20 to 100,
      wherein the insulating thermally conductive sheet has an orientation degree as determined by an X-ray diffraction method in a thickness direction such that (Sum of the counts at [2Θ = 41 to 43°])/(Sum of the counts at [2Θ = 25 to 27°]) is 1 or greater.
<2> The insulating thermally conductive sheet according to <1>, wherein the sheet has an Askar C hardness of 20 to 60.
<3> The insulating thermally conductive sheet according to <1> or <2>, wherein the sheet has a thermal conductivity of 16 to 30 W/mK in the thickness direction.
<4> The insulating thermally conductive sheet according to any one of <1> to <3>, wherein the sheet has a dielectric breakdown voltage of 5 kV/mm or more.
<5> The insulating thermally conductive sheet according to any one of <1> to <4>, wherein the sheet has a specific gravity of 1.2 to 2.0.

### Advantageous Effects of Invention

The insulating thermally conductive sheet of the present invention has excellent thermal conductivity in the thickness direction and excellent electrical insulation capability, while the sheet has low degree of hardness and excellent flexibility.

### Brief Description of Drawings

[FIG. 1] is a perspective view showing an example of the mold used in a filling step.
[FIG. 2] is a cross-sectional view showing the cross-sectional structure of the mold shown in FIG. 1.
[FIG. 3] is an exploded perspective view showing an example of the mold used in a molding step.

### Description of Embodiments

The present invention will be described in detail hereunder but the invention shall not be limited to the following.

### [Insulating thermally conductive sheet]

The insulating thermally conductive sheet of the present invention is a cured product of a thermally conductive silicone resin composition containing a thermosetting silicone resin and a boron nitride, preferably a molded product of a thermally conductive silicone resin composition containing boron nitride in the thermosetting silicone resin, which is molded using the method described below. Details are provided below.

### [Thermally conductive silicone resin composition]

The thermally conductive silicone resin composition essentially contains (A) a thermosetting silicone resin and (B) a boron nitride. The thermosetting silicone resin (A) is a thermosetting silicone resin (addition-curable organopolysiloxane composition) containing the following components (A1) to (A3) of:
(A1) an organopolysiloxane having two or more silicon atom-bonded alkenyl groups in each molecule;
(A2) an organohydrogenpolysiloxane; and
(A3) a hydrosilylation catalyst.

### [(A1) Organopolysiloxane having two or more silicon atom-bonded alkenyl groups in each molecule]

The component (A1) is an organopolysiloxane having two or more silicon atom-bonded alkenyl groups in each molecule, and serves as the main ingredient of the thermally conductive silicone resin composition. Typically, the organopolysiloxane has a backbone composed mainly of repeating diorganosiloxane units. Although it may contain a branched structure as a part of the molecule structure or be a cyclic structure, from the aspect of physical properties such as mechanical strength of a cured product, a linear diorganopolysiloxane is preferable.

Examples of the alkenyl group include those having typically about 2 to 8 carbon atoms such as a vinyl group, an allyl group, a propenyl group, an isopropenyl group, a butenyl group, a hexenyl group, and a cyclohexenyl group. Of these, preferred are lower alkenyl groups having 2 to 4 carbon atoms such as a vinyl group and an allyl group, among which a vinyl group is particularly preferred. Furthermore, it is necessary for the two or more alkenyl groups to be present in one molecule, and in order to improve the flexibility of the resulting cured product, it is more preferable for the component (A1) to have alkenyl groups bonded only to silicon atoms at both ends of the molecular chain.

Examples of groups to which silicon atoms are bonded, other than the above-mentioned alkenyl groups, include is a monovalent hydrocarbon group, and specifically, preferred are those having 1 to 10 carbon atoms, particularly 1 to 6 carbon atoms. Examples of the monovalent hydrocarbon group include an alkyl group such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, and a decyl group; a cycloalkyl group such as a cyclopentyl group, a cyclohexyl group, and a cycloheptyl group; an aryl group such as a phenyl group, a tolyl group, a xylyl group, and a naphthyl group; an aralkyl group such as a benzyl group, a phenylethyl group, a phenylpropyl group, and a methylbenzyl group. Preferred are alkyl groups having 1 to 3 carbon atoms such as a methyl group, an ethyl group, and a propyl group; and phenyl groups. Further, the groups to which silicon atoms are bonded, other than the alkenyl group, are not limited to all being the same, and a plurality of different groups may be bonded to the silicon atom.

It is preferred that the organopolysiloxane as the component (A1) normally exhibit the kinematic viscosity at 25°C in the range of 10 to 100,000 mm²/s, particularly preferably in the range of 100 to 100,000 mm²/s. If the kinematic viscosity is 10 mm²/s or more, the storage stability of the obtained resin composition is good, while if it is 100,000 mm²/s or less, the extensibility of the obtained resin composition is not impaired.

In addition, the kinematic viscosity as used in this specification refers to a value at 25°C using a Cannon-Fenske viscometer described in JIS Z 8803:2011.

One kind of the organopolysiloxane of component (A1) may be used alone, or two or more kinds thereof having different structures or kinematic viscosities may be used in combination.

### [(A2) Organohydrogenpolysiloxane]

The component (A2) is an organohydrogenpolysiloxane, and is characterized by being a mixture of the components (A2-a) and (A2-b) as set forth below.

### (A2-a) Organohydrogenpolysiloxane represented by the following formula (a):

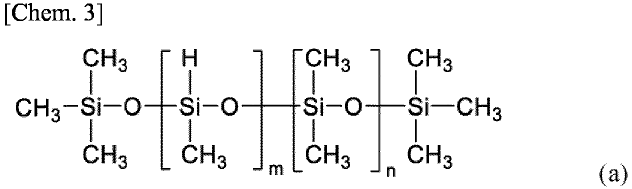

wherein m is 2 or 3, n is a number of 10 to 50, and the bonding arrangement of siloxane units each identified by m and n in brackets may be block or random.

### (A2-b) Organohydrogenpolysiloxane represented by the following formula (b):

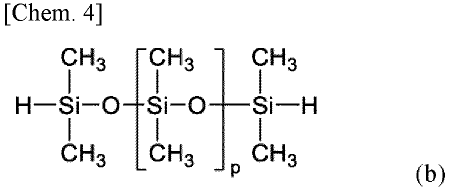

wherein p is a number of 10 to 30.

The organohydrogenpolysiloxane of the component (A2-a) is an organohydrogenpolysiloxane having two or three hydrogen atoms directly bonded to silicon atoms (hydrosilyl groups) in one molecule, and is a component that acts as a crosslinking agent of the component (A1). That is, the hydrosilyl groups in the component (A2-a) are added to the alkenyl groups in the component (A1) via a hydrosilylation reaction facilitated by the hydrosilylation catalyst of the component (A3), which will be described later, thereby forming a three-dimensional network structure.

Meanwhile, the organohydrogenpolysiloxane having hydrosilyl groups only at both ends of the component (A2-b) only serves to extend the molecular chain and does not impede the free movement of the molecules, even when added to alkenyl groups in the component (A1).

The molar ratio between the component (A2-a) and the component (A2-b) is determined such that the component (A2-a): the component (A2-b) = 1:0.2 to 1:2, and it is more preferred that the ratio be 1:0.3 to 1:1.6, and it is even more preferred that the ratio be 1:0.4 to 1:0.8. When the ratio between the components (A2-a) and (A2-b) becomes 1:a value of 0.2 or less, the content of the chain length extension decreases and the flexibility of the cured product is impaired. On the other hand, if the ratio between the components (A2-a) and (A2-b) becomes 1:a value exceeding 2, the content of the three-dimensional crosslinked structure decreases, making it difficult to cure the composition.

The component (A2) is added in such an amount to provide 0.7 to 1.2 moles of hydrosilyl groups in the component (A2) per one mole of alkenyl groups in the component (A1) (i.e., the number of moles of hydrosilyl groups is 0.7 to 1.2 times the number of moles of the alkenyl groups in the component (A1)). If the amount of hydrosilyl groups in the component (A2) becomes less than 0.7 mole per 1 mole of alkenyl groups in the component (A1), the material does not cure. If the amount exceeds 1.2 mole, the cured product loses its flexibility and becomes brittle.

### [(A3) Hydrosilylation catalyst]

The hydrosilylation catalyst as the component (A3) is a catalyst for facilitating the addition reaction between the alkenyl groups in the component (A1) and the hydrosilyl groups in the component (A2), and an example of which includes any of well-known catalysts to be used for hydrosilylation reaction. Specific examples thereof include elemental platinum group metals such as platinum (including platinum black), rhodium, and palladium; platinum chlorides, chloroplatinic acids and chloroplatinic acid salts such as H₂PtCl₄·nH₂O, H₂PtCl₆·nH₂O, NaHPtCl₆·nH₂O, KHPtCl₆·nH₂O, Na₂PtCl₆·nH₂O, K₂PtCl₄·nH₂O, PtCl₄·nH₂O, PtCl₂, Na₂HPtCl₄·nH₂O wherein n is an integer from 0 to 6, preferably 0 or 6; alcohol-modified chloroplatinic acids (see U.S. Pat. No. 3,220,972); complexes of chloroplatinic acid with olefins (see U.S. Pat. No. 3,159,601, U.S. Pat. No. 3,159,662, and U.S. Pat. No. 3,775,452); supported catalysts of platinum group metals, such as platinum black and palladium, on supports such as alumina, silica and carbon; rhodium-olefin complexes; chlorotris(triphenylphosphine)rhodium (known as Wilkinson's catalyst); and complexes of platinum chloride, chloroplatinic acid or chloroplatinic acid salts with vinyl group-containing siloxanes, particularly vinyl group-containing cyclic siloxanes.

The content of the component (A3) is 100 to 3,000 ppm, preferably 100 to 2,000 ppm, in terms of mass of platinum group metal element relative to the component (A1). If the content of the component (A3) is 100 ppm or more, sufficient catalytic activity can be obtained, while if it is 3,000 ppm or less, the effect of facilitating the addition reaction is sufficient and costs can be reduced.

### [(B) Boron nitride]

The component (B) of boron nitride is a particle that is oriented in the thickness direction of the insulating thermally conductive sheet (hereinafter also simply referred to as "sheet") and promotes heat conduction. From the viewpoint of thermal conductivity and electrical insulation in the thickness direction of the sheet, hexagonal boron nitride is particularly preferable as the boron nitride of the component (B). Further, the shape thereof is determined such that it has a specific average particle diameter and aspect ratio as described later, and is preferably the one that is flat, scale-like, plate-like, or flake-like.

The boron nitride has an aspect ratio of 20 to 100, preferably of 30 to 100, and more preferably of 50 to 100. The aspect ratio of 20 or more ensures the orientation capability that is important for improving heat conduction, and can provide enhanced heat conductivity in the thickness direction of the sheet. Moreover, the aspect ratio of 100 or less allows the sheet to maintain its flexibility.

The aspect ratio as used in this specification refers to a value obtained by dividing the major axis diameter of the particle by the thickness of the particle, i.e., major axis diameter/thickness. When the particle is spherical, the aspect ratio is 1, and the aspect ratio increases as the degree of flatness increases.

The aspect ratio as used in this specification refers to a value obtained by measuring the major axis diameter and thickness of the particle at a magnification of 1500 times using a scanning electron microscope and calculating the major axis diameter /thickness.

The average particle diameter of the boron nitrides is 40 to 100 µm, more preferably 40 to 90 µm, particularly preferably 50 to 80 µm. In order to impart flexibility to the sheet, it is necessary to efficiently form a heat conduction path in the thickness direction, and if the thickness is less than 40 µm, the thermal conductivity will be insufficient. Moreover, if it exceeds 100 µm, the flexibility of the sheet will be impaired. The boron nitrides may be of a uniform size having the average particle diameter, or a mixture of multiple types of boron nitrides having different average particle diameters.

The average particle diameter is a median diameter (a particle diameter for which, when powder ingredients are classified into two by a certain particle diameter, the amount of the particles larger than that particle diameter becomes equal to the amount of the particles smaller than that particle diameter; also generally referred to as D50) measured by a laser diffraction/scattering method using a laser diffraction/scattering particle size distribution analyzer.

The boron nitride may be contained therein in an amount of 150 to 500 parts by mass, preferably 200 to 400 parts by mass, per 100 parts by mass of the component (A). If the content of boron nitride is less than 150 parts by mass, sufficient thermal conductivity cannot be obtained in the thickness direction of the sheet, while if it exceeds 500 parts by mass, the sheet becomes rigid and lacks flexibility.

Additionally, insulating inorganic particles of, for example, alumina, magnesia, aluminum hydroxide, aluminum nitride, silicon nitride, and silica may be used in combination as long as they do not interfere with the orientation capability of boron nitrides. They are preferable in respect of processability because the viscosity of the composition can be adjusted by using it in combination with other insulating inorganic particles.

### [Further components]

The thermally conductive silicone resin composition may further be formulated with, as necessary, a component such as a solvent, a thixotropic agent, a dispersant, a curing agent, a curing accelerator, a retarder, a slight tackifier, a plasticizer, a flame retardant, an antioxidant, a stabilizers, and a colorant.

Furthermore, the thermally conductive silicone resin composition may be formulated with fillers other than the component (B). Specific examples thereof include silica and titanium oxide. The amount of such filler to be formulated is not particularly limited as long as it does not impair the advantageous effects of the present invention, but it is preferably 0 to 60 parts by mass, more preferably 0 to 40 parts by mass per 100 parts by mass of the component (A).

### [Method of manufacturing thermally conductive silicone resin composition]

The thermally conductive silicone resin composition may be manufactured by mixing (A) a thermosetting silicone resin, (B) a boron nitride, and optionally the further component using, for example, a mixer.

The thermally conductive silicone resin composition (A) may be prepared by mixing the component (A1), component (A2) composed of the components (A2-a) and (A2-b), and the component (A3) in advance to which the boron nitride (B) may then be further mixed, or the components including the boron nitride (B) may be mixed all at once without any preliminary mixture.

### [Method of manufacturing insulating thermally conductive sheet]

The method of manufacturing the insulating thermally conductive sheet of the present invention includes the steps of molding and curing the thermally conductive silicone resin composition, and examples of which include the following.

### [(1) Method of manufacturing insulating thermally conductive sheet]

An example method of manufacturing the insulating thermally conductive sheet of the present invention is a manufacturing method (1) involving:
a filling step of filling a thermally conductive silicone resin composition into a mold;
a vibrating step of vibrating the mold using ultrasonication to defoam the composition and align the boron nitride;
a heating step of heating the composition to obtain semi-cured silicone composition filaments from the thermally conductive silicone resin composition;
a molding step of arranging the semi-cured silicone composition filaments in a longitudinal direction, and heating and pressing the filaments to prepare a thermally conductive silicone molded product; and
a slicing step of slicing the thermally conductive silicone molded product to obtain an insulating thermally conductive sheet having a desired thickness.

This method allows the boron nitrides to be highly alighted to thereby provide an insulating thermally conductive sheet that is flexible and exhibit excellent thermal conductivity in the thickness direction

These steps in the manufacturing method (1) will be described in detail.

### Filling Step (1)

### (Mold used in the Filling step)

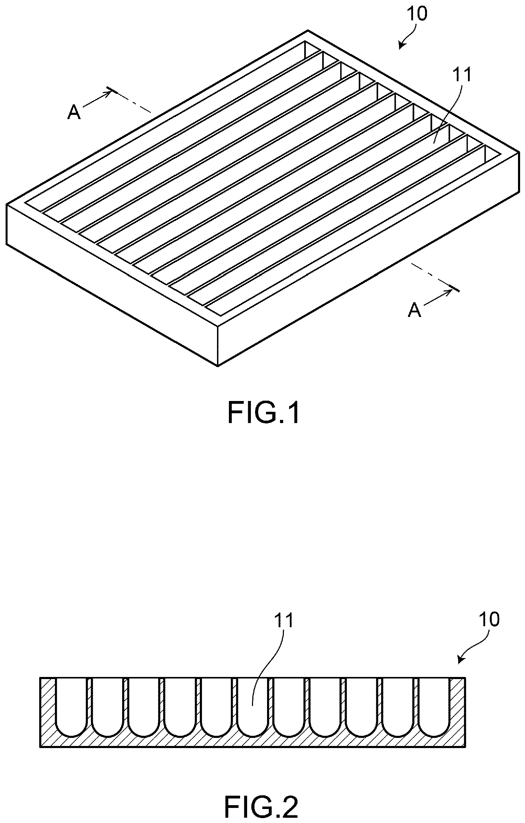

The mold used in the filling step has a width of 5.0 mm or less, a depth of the width length plus 1.0 mm or more, and a length of 10.0 mm or more. The mold may have any bottom shape that is not particularly limited, but examples of which include a wedge shape, a semicircular shape, a wavy shape, and a flat shape, and the mold has one or more grooves. FIG. 1 is a perspective view showing an example of the mold used in the filling step, and FIG 2 is a cross-sectional view of the mold shown in Figure 1 taken along the line A - A.

### (Filling Method)

In the filling step, a predetermined amount of the thermally conductive silicone resin composition may be filled into the grooves of the mold or an excessive amount of the thermally conductive silicone resin composition may be filled thereinto after which the redundant amount of the composition may be scraped off using a squeegee.

It is preferred that a solvent medium be added to the thermally conductive silicone resin composition because it decreases the viscosity of the composition and improves filling properties. Further, in the subsequent vibrating step for defoaming the composition and precipitating the boron nitride, it allows long axes of the boron nitride to readily arrange themselves in a longitudinal direction of the semi-cured silicone composition filaments.

### Vibrating Step (1)

The vibrating step is performed using ultrasonication to vibrate the mold filled with the thermally conductive silicone resin composition to thereby defoam the composition and align the boron nitride. In order to obtain semi-cured silicone composition filaments in the subsequent heating step, the mold may be vibrated using ultrasonication to deform the composition and precipitate and align the boron nitride to thereby allow long axes of the boron nitride to arrange themselves in a longitudinal direction of the semi-cured silicone composition filaments.

The frequency of the vibration step is preferably 28 to 120 kHz, more preferably 40 to 120 kHz. It is also preferred that the silicone resin composition have a temperature of 40°C or less during the vibration step so as not to accelerate the curing reaction.

### Heating Step (1)

The heating step is a step of heating the thermally conductive silicone resin composition in the mold after the thermally conductive silicone resin composition is filled thereinto and subjected to the vibrating step to prepare semi-cured silicone composition filaments formed along the shapes of the grooves in the mold. This step also includes a step of volatizing a solvent content by heat when the thermally conductive silicone resin composition contains a solvent. The heating temperature in the heating step is preferably 40 to 100°C, more preferably 60 to 80°C. The heating time is preferably 1 to 30 minutes, more preferably 1 to 10 minutes.

### Molding Step (1)

### (Mold used in the Molding step)

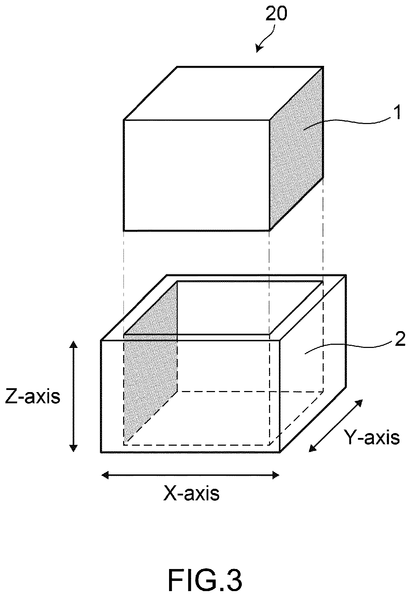

The mold used in the molding step has a recessed shape with an inner width of 10.0 mm or more, an inner length of 10 mm or more, and an inner depth of 10.0 mm or more, and the mold has a lower mold having a flat bottom shape, and an upper mold whose width and length are each 0.01 to 0.2 mm shorter than the inner dimensions of the lower mold. The upper mold may have any height which is not particularly limited but it must be high enough to apply pressure to the upper mold. FIG. 3 is an exploded perspective view showing an example of the mold used in the molding step. The mold used in the molding step, shown in FIG. 3, has a lower mold with inner dimensions of 33.0 mm in width (X axis), 52.0 mm in length (Y axis), and 50.0 mm in depth (Z axis), and an upper mold with 32.9 mm in width (X axis), 51.9 mm in length (Y axis), and 40.0 mm in height (Z axis).

### (Filling method)

The resultant semi-cured silicone composition filaments prepared in the heating step are packed into the lower mold in a manner of (i) or (ii) as set forth below.
(i) The semi-cured silicone composition filaments are arranged so that their longitudinal directions are in parallel to the X-axis direction of the mold, and then stacked and packed in the Z-axis direction.
(ii) The semi-cured silicone composition filaments are arranged so that their longitudinal directions are in parallel to the Y-axis direction of the mold, and then stacked and packed in the Z-axis direction.

This process more efficiently and preferably provides a molded product whose boron nitrides are neatly oriented.

The pieces of semi-cured silicone composition filaments aligned in the X or Y direction may have any number which is not particularly limited and can be suitably determined based on, for example, the sizes of the lower mold and semi-cured silicone composition filaments. It is, however, preferred in terms of productivity that the number be 2 to 5,000, more preferably 5 to 3,000.

It is also preferred that the number of semi-cured silicone composition filaments stacked in the Z-axis direction be two or more (two or more stages), more preferably 5 to 3,000 (5 to 3,000 stages).

### (Molding method)

The molding step is a step of pressurizing the lower mold with the upper mold in the Z-axis direction and heating the same to fully cure the semi-cured silicone composition filaments to obtain a thermally conductive silicone molded product.

It is preferred that the pressurizing method be such that it gradually increases the pressure from atmospheric pressure to the desired pressure.

The pressure applied to the mold is appropriately selected depending on a desired shape and hardness of the thermally conductive silicone molded product, but is preferably 0.1 to 20.0 MPa, and more preferably 0.5 to 5.0 MPa.

It is preferred that the lower mold have a surface temperature of -10 to 40°C, more preferably of 0 to 30°C, when the mold is subjected to pressurization.

It is preferred that the lower mold have a surface temperature of 50 to 200°C, more preferably of 100 to 150°C, when the semi-cured silicone composition filaments are cured. The curing time is preferably from 1 minute to 24 hours, more preferably from 5 minutes to 1 hour.

### Slicing Step (1)

The slicing step is a step of slicing the thermally conductive silicone molded product prepared in the molding step to obtain an insulating thermally conductive sheet having a desired thickness.

Specifically, the molded product is sliced
in parallel to the Y-Z plane when composition filaments are packed in the manner of (i) in the molding step or
in parallel to the X-Z plane when composition filaments are packed in the manner of (ii) in the molding step
to have a desired thickness to thereby obtain an insulating thermally conductive sheet in which the longitudinal directions of boron nitrides are oriented toward the thickness direction of the sheet.

### [(2) Method of manufacturing insulating thermally conductive sheet]

An example method of manufacturing the insulating thermally conductive sheet, as an alternative to the above-explained manufacturing method, according to the present invention is a manufacturing method (2) involving:
an application step of applying a thermally conductive silicone resin composition onto a film separator using, for example, a baker-type film applicator to have a uniform thickness;
a heating step of heating the thermally conductive silicone resin composition to obtain a semi-cured silicone composition sheet from the thermally conductive silicone resin composition;
a cutting step of separating the thermally conductive silicone resin composition from the film separator and cutting the composition to fit a size of a mold to be used in a subsequent molding step;
a molding step of arranging the semi-cured silicone composition sheet in an application direction, and heating and pressing the sheet to prepare a thermally conductive silicone molded product; and
a slicing step of slicing the thermally conductive silicone molded product to obtain a thermally conductive sheet having a desired thickness.

These steps in the manufacturing method (2) will be described in detail.

### Application Step (2)

The application step is a step of applying a thermally conductive silicone resin composition onto a film separator, capable of separating the semi-cured silicone composition sheet in a subsequent heating step, using, for example, a baker-type film applicator to have a uniform thickness. This process allows the longitudinal directions of boron nitrides to be aligned toward the application direction (direction in parallel to the applied surface) of the semi-cured silicone composition sheet. The thermally conductive silicone resin composition is applied uniformly onto the film separator, for example, preferably to a thickness of 100 to 2,000 µm, more preferably 300 to 1,000 µm.

### Heating Step (2)

The heating step is a step of heating the thermally conductive silicone resin composition, applied onto the film separator in the application step, to prepare a semi-cured silicone composition sheet. This step also includes a step of volatilizing a solvent content by heat when the thermally conductive silicone resin composition contains a solvent. The heating temperature in the heating step is preferably 40 to 100°C, more preferably 60 to 80°C. The heating time is preferably 1 to 30 minutes, more preferably 1 to 10 minutes.

### Cutting Step (2)

The cutting step is a step of separating the semi-cured silicone composition sheet, obtained in the heating step, from a film separator and cutting the sheet to fit the size of the mold to be used in a subsequent molding step. The cutting size is preferably designed to have a width and length adjusted to -0.3 to -1.0 mm relative to the inner dimensions of the mold for allowing the semi-cured silicone composition sheets to be easily packed in a subsequent molding step.

### Molding Step (2)

### (Mold used in the Molding step)

The mold as used in the molding step (1) may be used.

### (Filling Method)

The resultant semi-cured silicone composition sheets obtained in the cutting step are packed into the lower mold in a manner of (i) or (ii) as set forth below.
(i) The semi-cured silicone composition sheets are arranged so that their application flowing directions are in parallel to the X-axis direction of the mold, and then stacked and packed in the Z-axis direction.
(ii) The semi-cured silicone composition sheets are arranged so that their application flowing directions are in parallel to the Y-axis direction of the mold, and then stacked and packed in the Z-axis direction.

This process more efficiently and preferably provides a molded product whose boron nitrides are neatly oriented.

The pieces of semi-cured silicone composition sheets arranged in the X or Y direction may have any number which is not particularly limited and is suitably determined based on, for example, the sizes of the lower mold and the sizes and thicknesses of the semi-cured silicone composition sheets. It is, however, preferred in terms of productivity that the number be 1 to 10, more preferably 1 to 5.

It is also preferred that the number of semi-cured silicone composition sheets stacked in the Z-axis direction be two or more (two or more stages), more preferably 5 to 3,000 (5 to 3,000 stages).

### (Molding Method)

The molding step is a step of pressurizing the lower mold with the upper mold in the Z-axis direction and heating the same to fully cure the semi-cured silicone composition sheets to obtain a thermally conductive silicone molded product.

It is preferred that the pressurizing method be such that it gradually increases the pressure from atmospheric pressure to the desired pressure.

The pressure applied to the mold is appropriately selected depending on a desired shape and hardness of the thermally conductive silicone molded product, but is preferably 0.1 to 20.0 MPa, more preferably 0.5 to 5.0 MPa.

It is preferred that the lower mold have a surface temperature of -10 to 40°C, more preferably of 0 to 30°C, when the mold is subjected to pressurization.

It is preferred that the lower mold have a surface temperature of 50 to 200°C, more preferably 100 to 150°C, when the semi-cured silicone composition sheets are cured. The curing time is preferably from 1 minute to 24 hours, and more preferably from 5 minutes to 1 hour.

### Slicing Step (2)

The slicing step is a step of slicing the thermally conductive silicone molded product prepared in the molding step to obtain an insulating thermally conductive sheet having a desired thickness.

Specifically, the molded product is sliced
in parallel to the Y-Z plane when the sheets are packed in the manner of (i) in the molding step or
in parallel to the X-Z plane when the sheets are packed in the manner of (ii) in the molding step
to have a desired thickness to thereby obtain an insulating thermally conductive sheet in which the longitudinal directions of boron nitrides are oriented toward the thickness direction of the sheet.

### [Insulating thermally conductive sheet]

The insulating thermally conductive sheet of the present invention preferably has the following properties.

### [Orientation Degree]

The orientation degree is a ratio between peak intensities, detected by X-ray diffractometry, in the thickness direction of the insulating thermally conductive sheet, which is specifically defined as the sum of the counts at [2Θ = 41-43°]/the sum of the counts at [2Θ = 25-27°]. This orientation degree is 1 or greater, preferably 2 or greater.

### [Hardness]

It is preferred in terms of handleability and heat dissipation properties that the insulating thermally conductive sheet of the present invention have a hardness in which the Asker C hardness is 20 to 60, more preferably of 20 to 40. The Asker C hardness smaller than 20 may cause the sheet to be easily deformed and lose its orientation when handled, whereas the hardness exceeding 60 may enhance the contact thermal resistance between the sheet and the heating and cooling elements.

### [Thermal conductivity]

The insulating thermally conductive sheet has a thermal conductivity of preferably 16 to 30 W/mK, more preferably 18 to 26 W/mK in the thickness direction. This thermal conductivity is a value based on JIS R 1611:2010 and measured via a laser flash method (LFA 447 Nanoflash by NETZSCH-Geratebau GmbH).

### [Dielectric breakdown voltage]

The insulating thermally conductive sheet has a dielectric breakdown voltage of preferably higher than or equal to 5 kV/mm, more preferably higher than or equal to 8 kV/mm. This dielectric breakdown voltage is a value measured by a method based on JIS C 2110.

### [Specific gravity]

The insulating thermally conductive sheet has a specific gravity preferably of 1.2 to 2.0, more preferably of 1.4 to 1.8. This specific gravity is a value based on JIS K 6249:2003 and measured by in-water replacement method at 25°C using an automatic gravimeter (SGM-6 manufactured by Mettler-Toledo Inc.)

### Examples

The present invention will be specifically described with reference to Working Examples and Comparative Examples, but the present invention is not limited thereto.

Here, the kinematic viscosity is the value at 25°C using a Cannon-Fenske type viscometer described in JIS Z 8803:2011, and the aspect ratio is determined by SEM measurement, and the average particle diameter is a cumulative average particle diameter (median diameter) on a volume basis measured by a particle size analyzer, Microtrac MT3300EXII, manufactured by MicrotracBEL Corp.

### (Preparation of thermally conductive silicone resin composition)

The components (A) to (C) used in the following Working Examples are shown below.

### Component (A1): Alkenyl group-containing organopolysiloxane represented by the following formula:

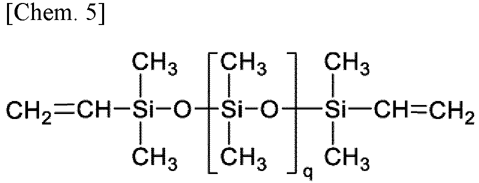

(A1-a) An organopolysiloxane in which q in the above formula is a number that makes the kinematic viscosity at 25°C 600 mm²/s
(A1-b) An organopolysiloxane in which q in the above formula is a number that makes the kinematic viscosity at 25°C 100,000 mm²/s

### Component (A2): Organohydrogenpolysiloxane represented by the following formula (A2-a)

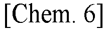

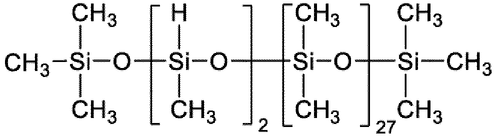

(The arrangement order of the siloxane units in brackets is not specifically limited.) (A2-b)

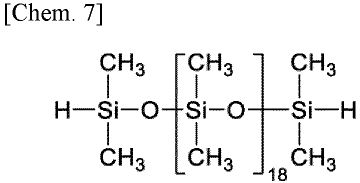

### Component (A3): 5% chloroplatinic acid 2-ethylhexanol solution

### Component (B): boron nitride with the average particle diameter and aspect ratio as shown below

(B1) HSPD50 (Average particle diameter 50 µm, aspect ratio 75, manufactured by Dandong Chemical Engineering Institute Co.)
(B2) HSPD (Average particle diameter 45 µm, aspect ratio 50, manufactured by Dandong Chemical Engineering Institute Co.)
(B3) HSP (Average particle diameter 40 µm, aspect ratio 30, manufactured by Dandong Chemical Engineering Institute Co.)
(B4) GP (Average particle diameter 8 µm, aspect ratio 10, manufactured by Denka Company Limited, for comparative example)
(B5) PTX-60 (Average particle diameter 55 µm, aspect ratio 1 spherical agglomerated powder, manufactured by Momentive Co., for comparative example)

### Component (C): Toluene as a diluting solvent during kneading

Predetermined amounts of each component shown in Table 1 below were kneaded for 60 minutes using a planetary mixer to obtain a thermally conductive silicone composition.

Hereinafter, molds used in Working Examples and Comparative Examples will be described with reference to the drawings.

FIG. 1 shows a perspective view of a mold used in the filling step. FIG. 2 shows a cross-sectional view taken along the line A-A of the mold used in the filling step shown in FIG. 1. The mold used in the filling step has a plurality of grooves each having a semicircular bottom surface with a width of 1.5 mm, a length of 50.0 mm, a depth of 2.5 mm, where the grooves are arranged in parallel to the long axis direction of the mold.

FIG. 3 illustrates an exploded perspective view showing the mold used in the molding step. The mold used in the molding step has a lower mold with inner dimensions of 33.0 mm in width (X axis), 52.0 mm in length (Y axis), and 50.0 mm in depth (Z axis), and an upper mold with 32.9 mm in width (X axis), 51.9 mm in length (Y axis), and 40.0 mm in height (Z axis).

### (Filling step)

The thermally conductive silicone resin composition prepared above was filled so as to overflow from the grooves of the mold used in the filling step, and the overflowed portion was scraped off with a squeegee.

### (Vibration step)

The molds filled with the thermally conductive silicone resin compositions of Working Examples 1 to 6 and Comparative Examples 1 to 8 were vibrated for 30 minutes using a tabletop ultrasonic cleaner UT-106 manufactured by Sharp Corporation under conditions of a water temperature of 25°C, a frequency of 37 kHz, and 100% output. The mold filled with the thermally conductive silicone resin composition of Comparative Example 9 was directly subjected to the subsequent heating step without undergoing the vibration step.

### (Heating step)

After the vibration step, the thermally conductive silicone resin composition in the mold was heated in an environment of 80°C for 2 minutes to obtain semi-cured silicone composition filaments. In Comparative Example 9, the vibration step was omitted, and the thermally conductive silicone resin composition in the mold after the filling step was heated in an environment of 80°C for 2 minutes to obtain semi-cured silicone composition filaments.

### (Molding step)

The semi-cured silicone composition filaments were packed into the lower mold shown in FIG. 3, arranged in 21 rows in the X-axis direction so that the longitudinal directions of the semi-cured silicone composition filaments were in parallel to the Y-axis direction of the mold, and further packed into 40 stages in the Z-axis direction. Then, while pressurized in the Z-axis direction at 1.0 MPa with a hydraulic press in the upper mold, the mixture was heated at 120°C for 30 minutes to obtain a molded product.

### (Slicing step)

The molded product was sliced with a cutter knife in parallel to the X-Z plane to obtain a sheet.

Table 1 shows the results of the following evaluation of the sheets obtained in Working Examples 1 to 6 and Comparative Examples 1 to 9.

### (Hardness)

A sheet sliced to a thickness of 12 mm was measured at 25°C using an Asker C hardness meter.

### (Thermal conductivity)

A sheet sliced to a thickness of 2 mm was punched out to obtain a circle test piece with a diameter of 12.7 mm. The thermal conductivity of this test piece was measured using a laser flash method (LFA 447 Nanoflash by NETZSCH-Geratebau GmbH) in accordance with JIS R 1611:2010.

### (Dielectric breakdown voltage)

A sheet sliced to a thickness of 1 mm was immersed in oil, and the dielectric breakdown voltage was measured by a method based on JIS C 2110.

### (Specific gravity)

The specific gravity of the sheet sliced to a thickness of 2 mm was measured at 25°C by in-water replacement method using an automatic gravimeter (SGM-6, manufactured by Mettler-Toledo Inc.) in accordance with JIS K 6249:2003.

### (Orientation Degree)

A sheet sliced to a thickness of 2 mm was punched out to obtain a circle test piece with a diameter of 12.7 mm. Measurements were performed on this test piece using a tabletop powder X-ray diffraction device D2 PHASER 2nd Generation manufactured by BRUKER JAPAN under the conditions of:
Scan range: 20 to 90°
Step size: 0.024°
Sample rotation: 10 rpm
Voltage: 30 kV and
Current: 10 mA,
to calculate the sum of the counts at 20 = 41 to 43° (100 plane) and the sum of the counts at 25 to 27° (002 plane).

The degree of orientation was defined by the following formula. Orientation degree = Sum of the counts at [2Θ = 41 to 43°] /Sum of the counts at [2Θ = 25 to 27°]

**[Table 1]**

| | Working example 1 | Working example 2 | Working example 3 | Working example 4 | Working example 5 | Working example 6 | Comparative example 1 | Comparative example 2 | Comparative example 3 | Comparative example 4 | Comparative example 5 | Comparative example 6 | Comparative example 7 | Comparative example 8 | Comparative example 9 |
|---|---|---|---|---|---|---|---|---|---|---|---|---|---|---|---|
| A1-a | 81 | 79 | 75 | 79 | 79 | 79 | 80 | 75 | 79 | 79 | 79 | 79 | 79 | 81 | 79 |
| A1-b | 9 | 10 | 12 | 10 | 10 | 10 | 10 | 9 | 10 | 10 | 10 | 10 | 10 | 9 | 10 |
| A2-a | 7.1 | 7.9 | 8.5 | 7.9 | 7.9 | 7.9 | 6.0 | 11.0 | 7.9 | 7.9 | 10.0 | | 7.9 | 7.1 | 7.9 |
| A2-b | 2.4 | 2.6 | 2.8 | 2.6 | 2.6 | 2.6 | 2.0 | 3.7 | 2.6 | 2.6 | | 11.0 | 2.6 | 2.4 | 2.6 |
| A3 | 0.8 | 0.9 | 1.1 | 0.9 | 0.9 | 0.9 | 0.9 | 0.8 | 0.9 | 0.9 | 0.9 | 0.9 | 0.9 | 0.8 | 0.9 |
| B1 | 228 | 251 | 308 | | | 251 | 255 | 240 | | | 251 | 251 | 140 | 550 | 251 |
| B2 | | | | 251 | | | | | | | | | | | |
| B3 | | | | | 251 | | | | | | | | | | |
| B4 | | | | | | | | | 251 | | | | | | |
| B5 | | | | | | | | | | 251 | | | | | |
| C | 31 | 40 | 56 | 40 | 40 | 0 | 64 | 60 | 63 | 63 | 63 | 63 | 63 | 48 | 63 |
| Component A in parts by mass | 100 | 100 | 100 | 100 | 100 | 100 | 100 | 100 | 100 | 100 | 100 | 100 | 100 | 100 | 100 |
| Component 8 in parts by mass | 228 | 251 | 308 | 251 | 251 | 251 | 255 | 240 | 251 | 251 | 251 | 251 | 140 | 550 | 251 |
| Molar ratio of A2 hydrosilyl groups to A1 alkenyl groups | 0.79 | 0.89 | 1.00 | 0.89 | 0.89 | 0.89 | 0.67 | 1.31 | 0.89 | 0.89 | 0.77 | 1.18 | 0.89 | 0.79 | 0.89 |
| Hardness | 42 | 48 | 55 | 48 | 48 | 51 | No curing observed | 78 | 51 | 54 | 71 | No curing observed | 28 | 86 | 44 |
| Thermal conductivity (W/mK) | 16 | 19 | 30 | 17 | 16 | 20 | | 18 | 4 | 9 | 19 | | 11 | 32 | 13 |
| Dielectric breakdown voltage (kV/mm) | 10 | 10 | 10 | 10 | 10 | 11 | | 10 | 18 | 16 | 10 | | 11 | 7 | 11 |
| Specific gravity | 1.5 | 1.5 | 1.6 | 1.5 | 1.5 | 1.5 | | 1.50 | 1.52 | 1.52 | 1.51 | | 1.31 | 1.56 | 1.5 |
| Orientation degree | 2.4 | 3.0 | 5.2 | 3.1 | 2.9 | 3.6 | | 2.6 | 1.3 | 0.8 | 2.8 | | 1.6 | 5.8 | 0.5 |

As can be seen from Working Examples 1 to 3 and Comparative Examples 1 and 2, it was found that a sheet with an appropriate hardness could be obtained by adjusting the molar ratio of the hydrosilyl groups in the component (A2) to the alkenyl groups in the component (A1). Meanwhile, a ratio of the component (A2) inappropriately adjusted, as were the cases of Comparative Examples 5 and 6, increased the hardness of the sheet, thus making the molding itself difficult. Moreover, as can be seen from Comparative Examples 7 and 8, it was found that an excessive content of boron nitride increases the hardness of the sheet, while insufficient content of boron nitride reduces its thermal conductivity.

The results of Working Examples 4 and 5 and Comparative Example 3 indicate that an average particle diameter of boron nitride greater than or equal to 40 µm leads to a favorable thermal conductivity.

In addition, the sheet of Comparative Example 9, which was manufactured without undergoing a vibration step during the manufacturing step and in which the degree of orientation of boron nitride in the sheet thickness direction was less than 1, failed to form a good heat conduction path and had a lower thermal conductivity compared to that of the sheet of Working Example 2 whose boron nitride content in the sheet is in a comparable amount thereof.

### Reference Signs List

- 10: Mold used in the filling step
- 11: Grooves in Mold used in the filling step
- 20: Mold used in the filling step
- 1: Upper mold used in the molding step
- 2: Lower mold used in the molding step

## Claims

1. An insulating thermally conductive sheet of a cured product of a thermally conductive silicone resin composition comprising:
(A) 100 parts by mass of a thermosetting silicone resin containing the following components (A1) to (A3) of
(A1) an organopolysiloxane having two or more silicon atom-bonded alkenyl groups in each molecule,
(A2) an organohydrogenpolysiloxane in an amount such that a molar ratio of the total amount of hydrosilyl groups in the component (A2) to the amount of the silicon atom-bonded alkenyl groups in the component (A1) is 0.7 to 1.2, said organohydrogenpolysiloxane being composed of the following components (A2-a) and (A2-b) of
(A2-a) an organohydrogenpolysiloxane defined by the following formula (a): 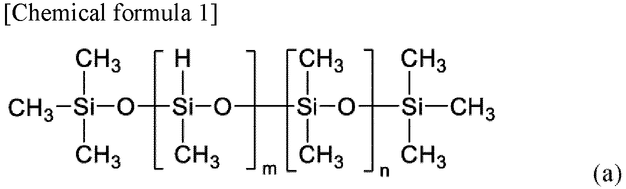 wherein m is 2 or 3, n is a number of 10 to 50, and the bonding arrangement of siloxane units each identified by m and n in brackets may be blocked or random, and
(A2-b) an organohydrogenpolysiloxane defined by the following formula (b): 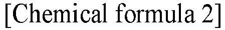 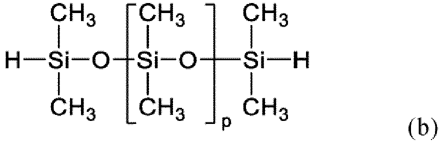 wherein p is a number of 10 to 30,
wherein a molar ratio between the components (A2-a) and (A2-b) is determined such that the component (A2-a):the component (A2-b) = 1:0.2 to 1:2, and
(A3) a hydrosilylation catalyst in an amount of 100 to 3,000 ppm in terms of platinum group metal atom per 100 parts by mass of the component (A1); and
(B) 150 to 500 parts by mass of a boron nitride that has an average particle diameter of 40 to 100 µm as determined by a laser diffraction/scattering method and an aspect ratio of 20 to 100,
wherein the insulating thermally conductive sheet has an orientation degree as determined by an X-ray diffraction method in a thickness direction such that (Sum of the counts at [2Θ = 41 to 43°])/(Sum of the counts at [2Θ = 25 to 27°]) is 1 or greater.

2. The insulating thermally conductive sheet according to claim 1, wherein the sheet has an Askar C hardness of 20 to 60.

3. The insulating thermally conductive sheet according to claim 1 or 2, wherein the sheet has a thermal conductivity of 16 to 30 W/mK in the thickness direction.

4. The insulating thermally conductive sheet according to claim 1, wherein the sheet has a dielectric breakdown voltage of 5 kV/mm or more.

5. The insulating thermally conductive sheet according to claim 1, wherein the sheet has a specific gravity of 1.2 to 2.0.
